(19)

Europäisches Patentamt

European Patent Office

Office européen des brevets

(11)  **EP 4 011 539 A1**

(12)  # EUROPEAN PATENT APPLICATION
published in accordance with Art. 153(4) EPC

(43) Date of publication:
**15.06.2022 Bulletin 2022/24**

(21) Application number: **20850710.3**

(22) Date of filing: **05.08.2020**

(51) International Patent Classification (IPC):
**B23K 1/00** (2006.01)          **C22C 13/00** (2006.01)
**B23K 35/14** (2006.01)        **B23K 35/26** (2006.01)
**B23K 35/40** (2006.01)

(52) Cooperative Patent Classification (CPC):
**B23K 1/00; B23K 35/26; B23K 35/40; C22C 13/00**

(86) International application number:
**PCT/JP2020/030074**

(87) International publication number:
**WO 2021/025081 (11.02.2021 Gazette 2021/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **05.08.2019 JP 2019144049**

(71) Applicants:
• **Nihon Superior Co., Ltd.**
**Osaka 564-0063 (JP)**
• **Merck Patent GmbH**
**64293 Darmstadt (DE)**

(72) Inventors:
• **NISHIMURA, Tetsuro**
**Suita-shi, Osaka 564-0063 (JP)**
• **NISHIMURA, Takatoshi**
**Tokyo 135-0042 (JP)**
• **AKAIWA, Tetsuya**
**Toyonaka-shi, Osaka 561-0894 (JP)**
• **YASU, Katsuhiko**
**Tokyo 153-0064 (JP)**
• **UNO, Hikaru**
**Tokyo 153-0064 (JP)**

(74) Representative: **Vossius & Partner
Patentanwälte Rechtsanwälte mbB
Siebertstraße 3
81675 München (DE)**

(54)  **SOLDER-METAL MESH COMPOSITE MATERIAL AND METHOD FOR PRODUCING SAME**

(57)  Provided is a solder-metal mesh composite material in which a lead-free solder layer formed of Sn-Cu-Ni-based lead-free solder contains metal mesh having high thermal conductivity, a void occupancy in a cross-section in a thickness direction is 15% or less, and the Sn-Cu-Ni-based lead-free solder contains 0.1 to 2% by weight of Cu, 0.002 to 1% by weight of Ni, and Sn as a remainder or contains 0.1 to 2% by weight of Cu, 0.002 to 1% by weight of Ni, 0.001 to 1% by weight of Ge, and Sn as a remainder. The solder-metal mesh composite material of the present invention has heat resistance, and has such high joint reliability as to exhibit excellent thermal conductivity, and the number of voids is small in a solder joint body. Therefore, when used as a solder joint member in a joint portion of an electronic device or a heat dissipating material, the solder-metal mesh composite material can efficiently transmit heat generated by an electronic component and can form a joint portion having such high joint reliability as to exhibit more excellent thermal conductivity.

FIG. 1

EP 4 011 539 A1

**Description**

TECHNICAL FIELD

The present invention relates to a solder-metal mesh composite material and a method for producing the same. Particularly, the present invention relates to a solder-metal mesh composite material that is preferably used for joining electronic components in an electronic circuit to be exposed to a high temperature, and a method for producing the same. Furthermore, the present invention relates to a solder joint body formed by using the solder-metal mesh composite material.

BACKGROUND ART

In recent years, semiconductor devices (power devices) have received attention, which are used in power converters such as inverters and converters for electric vehicles, hybrid vehicles, air conditioners, various types of general-purpose motors, and the like, as devices used for effective utilization for energy.

Regarding the power device, a device with little power loss in power conversion and can be used even in a high-voltage applied environment is considered to have a higher performance. Furthermore, the power device is also required to operate in a high temperature state since a cooling mechanism of a system is, for example, required to have a reduced size.

Therefore, in a power device required to have the above-described performance, solder as a member for joining electronic components to each other is also required to have a performance for enduring a high temperature operation in a high-voltage applied environment. However, it is widely known that, if an electronic component is in a high temperature state or subjected to temperature change, strength of a joint portion between the electronic components is reduced.

One of techniques for solving the above-described problem is development in a composite material in which thin Cu and Ni metal mesh is embedded in an SAC305 (an alloy that is formed of "tin (Sn)/silver (Ag)/copper (Cu)" and is represented as Sn-3.0Ag-0.5Cu, and that contains 3.0% by weight of silver, 0.5% by weight of copper, and tin as a remainder) solder joint portion (Non-Patent Literature 1).

However, nowadays, price for metals fluctuates and rises, and metals used for solder alloy are also affected. Particularly, since influence of price for silver is great, solder such as the above-described SAC305 solder in which a content of silver is as much as 3.0% by weight is not preferable from the viewpoint of cost.

CITATION LIST

[NON PATENT LITERATURE]

[NPL 1] Adrian Lis et al., Materials and Design 160 (2018) 475-485

SUMMARY OF THE INVENTION

PROBLEMS TO BE SOLVED BY THE INVENTION

An object of the present invention is to provide a solder-metal mesh composite material that has heat resistance and excellent thermal conductivity so as to exhibit high joint reliability, and a method for producing the same. Another object of the present invention is to provide a solder joint body formed by using such a solder-metal mesh composite material.

SOLUTION TO THE PROBLEMS

The inventors of the present invention have performed thorough studies for solving the above-described problem, and have found that if metal mesh having high thermal conductivity is contained in a lead-free solder layer formed of specific Sn-Cu-Ni-based lead-free solder, a lead-free solder layer that exhibits heat resistance and excellent thermal conductivity can be obtained. In the obtained lead-free solder layer, solder has excellent fluidity during production process steps, and excellent development properties during application of pressure. Accordingly, the lead-free solder layer can be easily adjusted to a desired thickness. Furthermore, generation of voids that affect the heat resistance and the thermal conductivity is reduced in a solder joint body obtained after joining. Thus, the inventors complete the present invention.

That is, the gist of the present invention is

    (1) a solder-metal mesh composite material in which a lead-free solder layer formed of Sn-Cu-Ni-based lead-free solder contains metal mesh having high thermal conductivity, a void occupancy in a cross-section in a thickness direction is 15% or less, and the Sn-Cu-Ni-based lead-free solder contains 0.1 to 2% by weight of Cu, 0.002 to 1% by weight of Ni, and Sn as a remainder or contains 0.1 to 2% by weight of Cu, 0.002 to 1% by weight of Ni, 0.001 to 1% by weight of Ge, and Sn as a remainder,

(2) the solder-metal mesh composite material according to the above-described (1) in which the metal mesh is copper mesh,

(3) a solder joint body formed by using the solder-metal mesh composite material according to the above-described (1) or (2),

(4) a method for producing a solder-metal mesh composite material, the method including:

coating a surface of metal mesh having high thermal conductivity with Sn-Cu-Ni-based lead-free solder to obtain solder-coated metal mesh;
disposing the solder-coated metal mesh between sheets of Sn-Cu-Ni-based lead-free solder and subsequently performing heating to a melting point of the Sn-Cu-Ni-based lead-free solder or a higher temperature while applying pressure, to melt the sheets of the lead-free solder; and
cooling the melted solder until the melted solder is solidified, and collecting a solder-metal mesh composite material, in which
the Sn-Cu-Ni-based lead-free solder contains 0.1 to 2% by weight of Cu, 0.002 to 1% by weight of Ni, and Sn as a remainder or contains 0.1 to 2% by weight of Cu, 0.002 to 1% by weight of Ni, 0.001 to 1% by weight of Ge, and Sn as a remainder,

(5) the method according to the above-described (4) in which the metal mesh is copper mesh, and

(6) the production method, according to the above-described (4) or (5), including disposing the sheet of the Sn-Cu-Ni-based lead-free solder, the solder-coated metal mesh, and the sheet of the Sn-Cu-Ni-based lead-free solder in order between a heat resistant plate A and a heat resistant plate B, and subsequently performing heating from an outside of the heat resistant plate B while pressure is applied from an outside of the heat resistant plate A.

ADVANTAGEOUS EFFECTS OF THE INVENTION

The solder-metal mesh composite material of the present invention has heat resistance and high joint reliability so as to exhibit excellent thermal conductivity. In addition, the number of voids is small in the solder joint body. Therefore, when used as a solder joint member in a joint portion of an electronic device or a heat dissipating material, the solder-metal mesh composite material can efficiently transmit heat generated by an electronic component and can form a joint portion having such high joint reliability as to exhibit more excellent thermal conductivity.

Therefore, the solder-metal mesh composite material of the present invention can be preferably used as, for example, a joint member of a heat dissipating material such as a heatsink member and a joint member of an electronic component in a semiconductor device (power device) used in a power converter such as an inverter and a converter for an electric vehicle, a hybrid vehicle, an air conditioner, various types of general-purpose motors, and the like.

BRIEF DESCRIPTION OF THE DRAWINGS

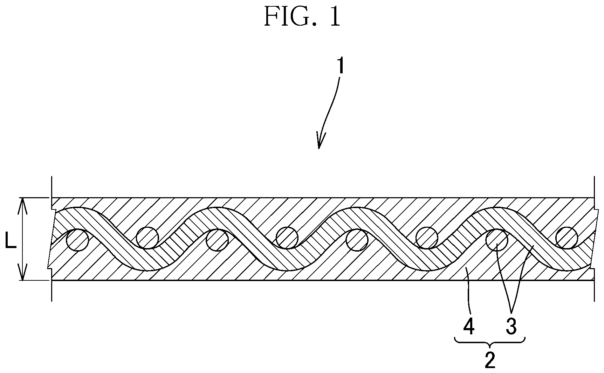

[FIG. 1] FIG. 1 is a schematic diagram illustrating a cross-section, in a thickness direction, of a solder-metal mesh composite material 1 of the present invention. In the solder-metal mesh composite material 1, a composite layer 2 as a lead-free solder layer formed of Sn-Cu-Ni-based lead-free solder includes metal mesh 3 having high thermal conductivity. The composite layer 2 mainly includes lead-free solder 4 and the metal mesh 3.

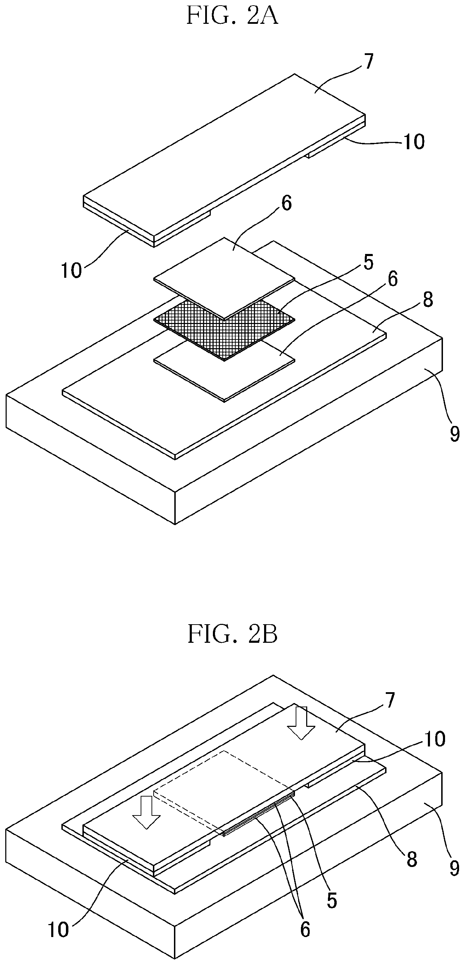

[FIG. 2] FIG. 2 is a schematic diagram illustrating an example of production of the solder-metal mesh composite material of the present invention. FIG. 2A illustrates a stacked state of members which have not been pressed and heated yet, and illustrates a state where an Sn-Cu-Ni-based lead-free solder sheet 6, solder-coated metal mesh 5, and the Sn-Cu-Ni-based lead-free solder sheet 6 are disposed in order, respectively, between a heat resistant plate A7 and a heat resistant plate B8, and are then placed on a heating device 9. FIG. 2B illustrates a state where, after the members are stacked on the heating device 9 as illustrated in FIG. 2A, the heating device 9 is heated to a desired temperature while pressure is applied to the heat resistant plate A7 from the upper side thereof to perform heating, from the heat resistant plate B8, to a melting point of the Sn-Cu-Ni-based lead-free solder or a higher temperature, and the lead-free solder sheets 6 are thus melted and integrated with the solder-coated metal mesh 5.

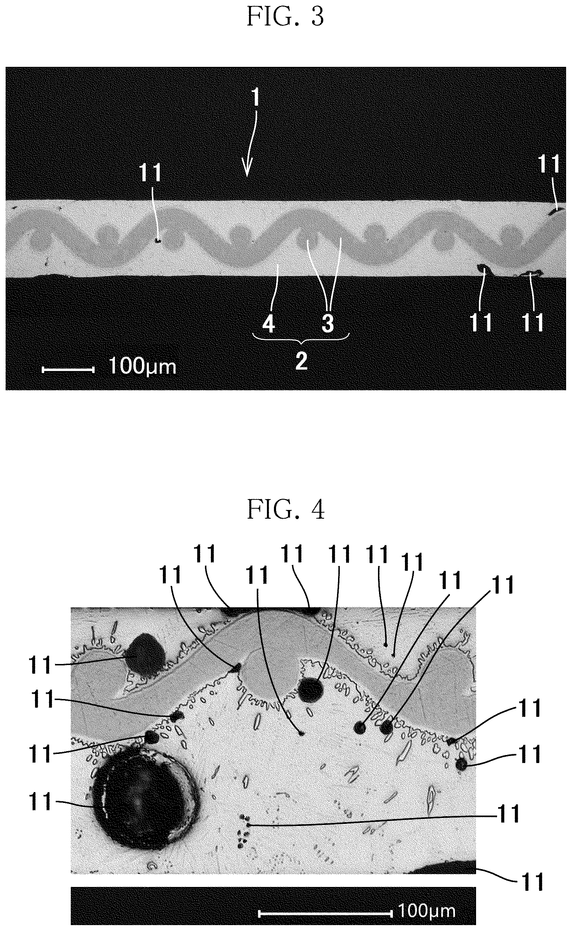

[FIG. 3] FIG. 3 illustrates an image that is obtained by observing the cross-section, in the thickness direction, of the solder-metal mesh composite material 1 obtained in example 1, by using a digital microscope, and illustrates a state where copper mesh 3 is contained in the composite layer 2 formed of the Sn-Cu-Ni-based lead-free solder in the solder-metal mesh composite material 1. In the composite layer 2, although voids 11 were observed, a void occupancy in the cross-section in the thickness direction was 1% or less.

[FIG. 4] FIG. 4 illustrates an image that is obtained by observing a cross-section, in a thickness direction, of a solder-metal mesh composite material obtained in comparative example 2A, by using a digital microscope.

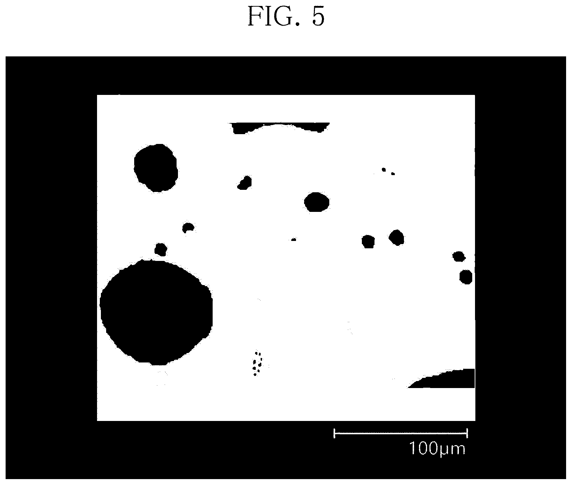

[FIG. 5] FIG. 5 illustrates a processed image obtained by performing binarization on the image illustrated in FIG. 4. A void occupancy in the cross-section, in the thickness direction, of a composite layer was 15.1%.

DESCRIPTION OF EMBODIMENTS

In a solder-metal mesh composite material 1 of the present invention, as illustrated in FIG. 1, a composite layer 2 formed of Sn-Cu-Ni-based lead-free solder contains metal mesh 3 having high thermal conductivity, a void occupancy in a cross-section in a thickness direction is 15% or less, and the Sn-Cu-Ni-based lead-free solder contains 0.1 to 2% by weight of Cu, 0.002 to 1% by weight of Ni, and Sn as a remainder or contains 0.1 to 2% by weight of Cu, 0.002 to 1% by weight of Ni, 0.001 to 1% by weight of Ge, and Sn as a remainder.

In the solder-metal mesh composite material 1 of the present invention, the composite layer 2 formed of the Sn-Cu-Ni-based lead-free solder basically includes the metal mesh 3 contained therein and Sn-Cu-Ni-based lead-free solder 4. An intermetallic compound generated through reaction between the lead-free solder 4 and the metal mesh 3 by heating during production as described below, may occur at an interface between the lead-free solder 4 and the metal mesh 3 (not illustrated).

The thickness of the composite layer 2 is not particularly limited as long as the effect of the present invention is exhibited.

Examples of the Sn-Cu-Ni-based lead-free solder (hereinafter, also referred to as lead-free solder) include lead-free solder that contains 0.1 to 2% by weight of Cu, 0.002 to 1% by weight of Ni, and Sn as a remainder, and lead-free solder that contains 0.1 to 2% by weight of Cu, 0.002 to 1% by weight of Ni, 0.001 to 1% by weight of Ge, and Sn as a remainder.

The lead-free solder is used for the solder-metal mesh composite material of the present invention, whereby a joint member containing the substantially small number of voids and having excellent thermal conductivity as described below, is obtained.

The lead-free solder having elements such as Bi, In, Sb, P, Ga, Co, Mn, Mo, Ti, Al, and Au added thereto may also be used. A content of each of the elements is not particularly limited and may be such an amount that does not substantially affect the thermal conductivity or the like of the lead-free solder.

In the present invention, the high thermal conductivity of the metal mesh refers to thermal conductivity higher than that of the lead-free solder.

Examples of a material of the metal mesh having the high thermal conductivity include metals having melting points higher than that of the lead-free solder, such as copper that is relatively inexpensive and has the thermal conductivity higher than that of the lead-free solder, an alloy that contains the copper as a main component, and an alloy that contains tin as a main component. Among them, copper (Cu) is preferable since the Sn-Cu-Ni-based lead-free solder has good wettability with respect to the metal mesh and the solder-metal mesh composite material of the present invention has high strength.

Although a shape of the metal mesh is not particularly limited as long as the effect of the present invention is exhibited, the metal mesh preferably has such a wire diameter as to facilitate control of a process step when the metal mesh is inserted and contained into the Sn-Cu-Ni-based lead-free solder, and to enhance strength of the solder-metal mesh composite material of the present invention.

Although the wire diameter is not particularly limited as long as the effect of the present invention is exhibited, the wire diameter is, for example, preferably 500 $\mu$m or less and more preferably 100 $\mu$m or less. An element wire of the metal mesh preferably has a round or ellipsoidal cross-sectional shape.

Although an opening of the metal mesh is not particularly limited as long as the effect of the present invention is exhibited, the opening may be such an opening that allows wettability of the Sn-Cu-Ni-based lead-free solder to be good; does not break the mesh during production process for the solder-metal mesh composite material of the present invention; and does not allow failure to occur when the metal mesh is inserted and contained into the lead-free solder.

Furthermore, the solder-metal mesh composite material in which the lead-free solder of the present invention contains the metal mesh having high thermal conductivity may also be processed to have a predetermined size through a rolling process causing no breakage of the metal mesh.

The size of the metal mesh is not particularly limited as long as the size is appropriate for allowing the metal mesh to be mounted on an electronic device.

In the solder-metal mesh composite material 1 of the present invention, a void occupancy in the cross-section in the thickness direction (L) refers to a void area (excluding an area of the copper wires) in one braided-wire intersecting section as a repeating unit of the metal mesh relative to the entirety of the area of the solder-metal mesh composite material 1.

The voids of the solder-metal mesh composite material 1 can be detected using an X-ray fluoroscope for observing a radiographic image from the vertically upper side or the vertically lower side of the solder-metal mesh composite material 1. Furthermore, an X-ray CT apparatus may be used as necessary. Subsequently, the cross-section, in the thickness direction, including the detected voids is observed by a digital microscope, and a void occupancy in the cross-section in the thickness direction can be measured from the obtained image in accordance with IEC61191-6:2010 that is the international standard defined by the International Electrotechnical Commission (IEC).

In the solder-metal mesh composite material 1 of the present invention, the void occupancy in the cross-section in the thickness direction (L) is 15% or less, and the void occupancy is preferably 10% or less and more preferably 5% or less from the viewpoint of excellent thermal conductivity and joint reliability.

For example, as in comparative example 2A described below, even the SAC305 that has been frequently used as a typical composition of the lead-free solder includes 15.1% of voids. As compared with the SAC305, in the solder-metal mesh composite material 1 according to example 1 of the present invention, the void occupancy in a solder joint body is low as described above. Therefore, when the solder-metal mesh composite material 1 is used as a solder joint member at a joint portion of an electronic device, heat generated by an electronic component can be efficiently transmitted, and a joint portion having such high joint reliability as to exhibit more excellent thermal conductivity can be formed.

As in example 1, in a case where the solder joint body is formed by using the solder-metal mesh composite material having a small void occupancy, generation of voids can be reduced at the obtained joint portion.

Examples of a method (hereinafter, also referred to as a method of the present invention) for producing the solder-metal mesh composite material of the present invention, which has the above-described structure, include a method including

a step (first step) of coating a surface of metal mesh having high thermal conductivity with Sn-Cu-Ni-based lead-free solder, to obtain solder-coated metal mesh,

a step (second step) of disposing the solder-coated metal mesh between Sn-Cu-Ni-based lead-free solder sheets, and then performing heating to a melting point of the Sn-Cu-Ni-based lead-free solder or a higher temperature while applying pressure, to melt the lead-free solder sheets, and

a step (third step) of cooling the melted solder until the solder is solidified and collecting the solder-metal mesh composite material.

In the first step, the surface of the metal mesh having high thermal conductivity is coated with the Sn-Cu-Ni-based lead-free solder, to obtain solder-coated metal mesh.

As in the first step, the surface of the metal mesh having high thermal conductivity is coated with the Sn-Cu-Ni-based lead-free solder, so that the lead-free solder sheets and the solder coating of the metal mesh are likely to have conformability with each other when melted in the second step. Therefore, uniformity can be obtained. As a result, reduction of voids generated in a composite material layer can be expected, so that the solder-metal mesh composite material can be efficiently produced while the void occupancy in the composite layer 2 is significantly reduced. Particularly, the Sn-Cu-Ni-based lead-free solder has excellent fluidity when melted, and quick coating of the opening portion of the metal mesh can thus be efficiently performed.

Examples of a method for coating the surface of the metal mesh having high thermal conductivity with the lead-free solder include, but are not particularly limited to, a method (dipping method) in which the metal mesh is dipped in the melted lead-free solder, a method in which the melted lead-free solder is poured onto the surface of the metal mesh, and a method in which the metal mesh is held between solder sheets from both sides of the metal mesh and the solder sheets are then melted.

The lead-free solder is heated to a melting point thereof or a higher temperature and melted, and then used in the coating.

In the coating state, the thickness of the coating is not particularly limited as long as gaps among meshes of the metal mesh are filled with the lead-free solder.

Furthermore, the coating with the lead-free solder can be finished well by previously adhering flux to the surface of the metal mesh before the coating with the lead-free solder.

Examples of a method for adhering the flux include, but are not particularly limited to, a method (dipping method) in which the metal mesh is dipped in the flux, and a method in which the flux is applied to the surface of the metal mesh.

Examples of the flux include flux in which the basic composition is a solvent and an activator that contains one selected from malonic acid, succinic acid, glutaric acid, adipic acid, suberic acid, azelaic acid, sebacic acid, maleic acid, citric acid, tartaric acid, and benzoic acid. Although the content of the activator is not particularly limited as long as the effect of the present invention is exhibited, the content of the activator is preferably 4.55 mmol/g to 45.5 mmol/g per flux content of 100g.

Although the solvent used for the flux is not particularly limited as long as the effect of the present invention is exhibited, examples of the solvent include: alcohols such as ethanol, isopropanol, and isobutanol; glycol ethers such as butyl carbitol and hexyl carbitol; glycols such as ethylene glycol and diethylene glycol; esters such as ethyl propionate and butyl benzoate; hydrocarbons such as n-hexane and dodecane; terpene derivatives such as 1,8-terpine monoacetate and 1,8-terpine diacetate, and isobornyl cyclohexanol. The content of the solvent can be set to any content as long as the effect of the activator, and flux coatability and stability are satisfactory.

After the coating, cooling is performed to obtain solder-coated metal mesh. The cooling temperature is not particularly limited as long as the cooling temperature is a melting point of the lead-free solder or a lower temperature.

In the second step, the solder-coated metal mesh is disposed between Sn-Cu-Ni-based lead-free solder sheets (hereinafter, also referred to as lead-free solder sheets), and heating to a melting point of the lead-free solder or a higher temperature is subsequently performed while pressure is applied, to melt the lead-free solder sheets.

In the second step, the solder-coated metal mesh is held between two lead-free solder sheets, and then pressure-applied and heated, whereby the lead-free solder with which the metal mesh is coated and the lead-free solder sheets are melted and integrated with each other. Since the metal mesh is previously coated with the lead-free solder, the lead-free solder sheets are melted and easily have conformability with the lead-free solder with which the metal mesh is coated, and advantageously, uniformity can be obtained and voids are unlikely to be generated even when the integration is performed.

If the lead-free solder contains, as its composition, 0.1 to 2% by weight of Cu, 0.002 to 1% by weight of Ni, 0.001 to 1% by weight of Ge, and Sn as a remainder, fluidity during melting is excellent. Therefore, when the metal mesh is dipped in the melted solder, the solder smoothly flows into the openings of the metal mesh. Since wettability of the solder with respect to the metal mesh is good, entering of voids is reduced, and the metal mesh can be uniformly coated. Furthermore, when the pressure-application and heating are performed after melting, the excellent fluidity advantageously inhibits generation of voids in the solder.

The size of the lead-free solder sheet is not particularly limited, and may be equal to the size of an electronic component of, for example, a semiconductor device or a heat dissipating material such as a heatsink member, which is a joining target. The thickness of the lead-free solder sheet is not particularly limited and may be adjusted as appropriate according to an object to which the solder-metal mesh composite material is applied.

Examples of a method for the second step include a method using pressure-application and heating as illustrated in FIGS. 2A and 2B. Specifically, as illustrated in FIG. 2A, the Sn-Cu-Ni-based lead-free solder sheet 6, the solder-coated metal mesh 5, and the Sn-Cu-Ni-based lead-free solder sheet 6 are firstly stacked and disposed in order, between a heat resistant plate A7 and a heat resistant plate B8.

The heat resistant plate A7 may be a sheet having a size and a thickness that facilitate application of pressure to the solder-coated metal mesh 5, the lead-free solder sheets 6, and the like, and the thickness and the size thereof are not particularly limited.

The size of the heat resistant plate A7 may be made greater than that of the solder-coated metal mesh 5, and a spacer 10 may be disposed around the solder-coated metal mesh 5.

Preferably, a material of each of the heat resistant plate A7 and the spacer has excellent heat resistance and good processability, and is low-priced. Examples of the material include, but are not particularly limited to, ceramics such as alumina and zirconia, aluminium, steel, and stainless steel.

Subsequently, as illustrated in FIG. 2B, while pressure is applied from the outside of the heat resistant plate A7, heating is performed from the outside of the heat resistant plate B8.

The pressure-applying means is not particularly limited as long as load is uniformly applied to the lead-free solder sheets and the metal mesh having high thermal conductivity. The pressure-applying means are exemplified by, for example, application of pressure by oil pressing or air pressing, or placement of weights.

A degree of the pressure application is not particularly limited as long as a thickness can be assured so as to exhibit the effect specific to the solder-metal mesh composite material of the present invention. The degree of the pressure application can be optionally set to a target degree appropriate for a joining target.

The heat resistant plate B8 may be a sheet having a size and a thickness that facilitate heating of the solder-coated metal mesh 5 and the lead-free solder sheets 6 that are stacked between the heat resistant plate A7 and the heat resistant plate B8. The thickness and the size of the heat-resistant plate B8 are not particularly limited.

Examples of means for heating the heat resistant plate B8 include a method in which the heating device 9 is connected to the lower face of the heat resistant plate B8 and a method in which the entirety of the heat resistant plate B8 is heated in a high-temperature bath.

The heating temperature may be a melting point of the lead-free solder of the lead-free solder sheet 6 or a higher temperature. The upper limit of the heating temperature is preferably adjusted to be within a temperature range up to the melting point of the lead-free solder + 50°C from the viewpoint of quality deterioration such as oxidation of the lead-free solder and economic efficiency.

For example, if the lead-free solder contains, as its composition, 0.1 to 2% by weight of Cu, 0.002 to 1% by weight of Ni, 0.001 to 1% by weight of Ge, and Sn as a remainder, the heating temperature is preferably adjusted to about 227 to 350°C, whereby the lead-free solder sheets 6 that hold the solder-coated metal mesh 5 from the upper and the lower sides can be efficiently melted. If the Sn-Cu-Ni-based lead-free solder contains 0.1 to 2% by weight of Cu, 0.002 to 1% by weight of Ni, and Sn as a remainder, the heating temperature is preferably adjusted to about 227 to 350°C.

In the third step, cooling is performed until the solder melted in the second step is solidified, and the solder-metal mesh composite material is collected.

Examples of a method for performing cooling until the solder of the melted lead-free solder sheets and the like is solidified include a method in which the cooling is performed while a pressure-applied state in the second step is maintained. Although the cooling temperature may be a temperature at which the lead-free solder is solidified or a lower temperature, the cooling is preferably performed at a lowest possible temperature from the viewpoint of efficient cooling.

After the cooling is performed until the melted solder is solidified as described above, the pressure-applied state is cancelled and the solder-metal mesh composite material is collected.

If the melted solder leaks and is solidified at the end portion of the solder-metal mesh composite material, the leaked portion may be cut or the solder-metal mesh composite material may be shaped into a desired shape. For example, in order to make the thickness of the solder-metal mesh composite material more uniform, the surface of the solder-metal mesh composite material may be ground or the surface may be flattened by using a triple-roll mill or a pressing machine. Furthermore, the solder-metal mesh composite material can be processed to have a predetermined size through a rolling process causing no breakage of the metal mesh.

The solder-metal mesh composite material of the present invention can be used as a joint member of an electronic component or a joint member of a heat dissipating material such as a heatsink member, similarly to conventional solder.

The solder joint body according to an embodiment is formed by using the solder-metal mesh composite material. The solder joint body includes a predetermined base member, and a joining portion which is formed of the solder-metal mesh composite material joined to the base member.

The base member is not particularly limited, and may be for an electronic component used in a semiconductor device (power device). The base member is not particularly limited, and may be a heat dissipating material such as a heatsink member.

A joining method using the solder-metal mesh composite material can be, for example, performed according to an ordinary method by using a reflow method.

The heating temperature may be adjusted as appropriate according to heat resistance of the base member or a temperature at which a solder alloy used for the solder-metal mesh composite material is melted.

For example, a pressure reducing process may be performed at the time of joining for reducing generation of voids in the joined body.

The solder joint body formed in this manner has heat resistance at the joint portion, and has such high joint reliability as to exhibit excellent thermal conductivity. Therefore, for example, even in a case where the joint portion is heated by heat generated by an electronic component in a high voltage applied environment, strain stress is unlikely to be generated in the joint portion, and resistance to stress can be exhibited.

Therefore, for example, the solder-metal mesh composite material of the present invention can be preferably used as a joint member of an electronic component in a semiconductor device (power device) used in a power converter such as an inverter and a converter for an electric vehicle, a hybrid vehicle, an air conditioner, various types of general-purpose motors, and the like.

The solder-metal mesh composite material of the present invention is also preferable for joining in a heat dissipating material such as a heatsink member having heat dissipating properties as significant characteristics, and the application thereof can be expected.

EXAMPLES

(Example 1)

Commercially available copper mesh (wire diameter of about 50 $\mu$m, opening of 75 $\mu$m, longitudinal dimension of 6 cm, transverse dimension of 6 cm) was dipped in a container having flux (NS-334 low-residue no-clean flux manufactured by NIHON SUPERIOR CO., LTD.) therein.

The copper mesh was taken out from the container, and an excess amount of the flux was removed. Subsequently, the obtained product was dipped in a container that had therein SN100C (lead-free solder, having a composition of Sn-0.7Cu0.05Ni+Ge, manufactured by NIHON SUPERIOR CO., LTD.) having been heated to 260°C and melted, to perform coating with the lead-free solder, the obtained product was taken out from the container, and an excess amount of the SN100C was removed to obtain solder-coated copper mesh.

Subsequently, as illustrated in FIG. 2A, the obtained solder-coated copper mesh 5 was held between two SN100C sheets 6 having the same size to produce a stacked product, and the stacked product was further held between an alumina plate A7 (longitudinal dimension of 2.5 cm, transverse dimension of 7.5 cm, thickness of 0.6 mm) and an alumina plate B8 (longitudinal dimension of 5 cm, transverse dimension of 5 cm, thickness of 500 $\mu$m) from the outside of the SN100C sheets 6, and placed on the heating device 9 from the alumina plate B8 side.

Spacers 10 each having a thickness of 120 $\mu$m were disposed at both ends of the alumina plate A7.

Subsequently, as illustrated in FIG. 2B, the temperature of the heating device 9 was adjusted to 227°C while a load of 0.5 atm was applied from the upper side of the alumina plate 7 using a pressure applying device. As a result, it was confirmed that the SN100C sheets 6 were melted, and the melted SN100C leaked from the above-described stacked product to the outside of the alumina plate 7. Thereafter, the heating was stopped.

Subsequently, cooling was performed by a locally-air-blowing machine, and, after the SN100C that leaked was confirmed to have solidified, the pressure-applied state was canceled, to obtain a solder-metal mesh composite material in which the SN100C lead-free solder layer contained the copper mesh.

(Test example 1)

In the solder-metal mesh composite material obtained in example 1, a void occupancy in the cross-section in the thickness direction was measured using an X-ray fluoroscope for observing a radiographic image from the vertically upper side or the vertically lower side of the solder-metal mesh composite material 1 in accordance with IEC61191-6:2010 (not illustrated).

Subsequently, an image was obtained by observing the cross-section in thickness direction by a digital microscope. FIG. 3 illustrates the image.

The void occupancy of the voids 11 in the cross-section in the thickness direction was measured based on the image illustrated in FIG. 3 in accordance with IEC61191-6:2010, and the measurement result was 1%.

Therefore, the solder-metal mesh composite material obtained in example 1 contained the copper mesh, and thus had high strength and excellent thermal conductivity. Furthermore, the number of voids in a solder joint body was significantly small. Therefore, for example, it was found that, also in a high-voltage applied environment, the solder-metal mesh composite material had higher heat resistance, had such high joint reliability as to exhibit more excellent thermal conductivity, and was capable of enduring the high-temperature operation.

Accordingly, the solder-metal mesh composite material obtained in example 1 was found to be preferably used as a joint member of a heat dissipating material such as a heatsink member and a joint member of an electronic component in a semiconductor device (power device) used in a power converter such as an inverter and a converter for an electric vehicle, a hybrid vehicle, an air conditioner, various types of general-purpose motors, and the like.

(Test example 2)

A sample 1 was produced in the same manner as in example 1 except that metal mesh was not used (comparative example 1).

For each of the samples (n = 4) of example 1 and comparative example 1, a density, a specific heat, and thermal diffusivity were measured according to the following procedures, and thermal conductivity was thereafter calculated.

<Measurement of density>

In accordance with the Archimedes' method, each of the samples of example 1 and comparative example 1 was sunk in water in a container having the inner diameter same as the diameter of the sample, and a volume of the sample was measured according to change between liquid levels obtained before and after the sample was put into the container, and the density was calculated from a weight of the sample.

<Measurement of specific heat>

A differential scanning calorimeter DSC3500 (manufactured by NETZSCH) was used to measure a specific heat of each of the samples of example 1 and comparative example 1 under an argon atmosphere at room temperature with a DSC method using sapphire as a reference substance.

<Measurement of thermal diffusivity>

For each of the samples, of example 1 and comparative example 1, which were blackened using an aerosol dry graphite film-forming lubricant DGF (manufactured by Nihon Senpakukougu Corporation), thermal diffusivity was measured at room temperature in the air atmosphere, using a laser flash analyzer LFA457 (manufactured by NETZSCH).

<Thermal conductivity>

For each of the samples of example 1 and comparative example 1, thermal conductivity was calculated according to the following equation from the density, the specific heat, and the thermal diffusivity obtained as described above.

$$\text{Thermal conductivity (W/(m·K))} = \text{thermal diffusivity (m}^2\text{/s)} \times \text{density (Kg/m}^3\text{)} \times \text{specific heat (J/(Kg·K))}$$

The results thereof are indicated in Table 1.

[Table 1]

| Sample | Solder alloy | Presence or absence of mesh | Density Kg/m$^3$ | Specific heat J/Kg·K | Thermal diffusivity m$^2$/s n=4 average value | Thermal conductivity W/m·K | Proportion in the case of thermal conductivity being "1" when mesh was absent | Relative value in the case of proportion of thermal conductivity of example 1 being 100 |
|---|---|---|---|---|---|---|---|---|
| Ex. 1 | SN100C | present | 7.7×10$^3$ | 249 | 102×10$^{-6}$ | 196 | 2.92 | 100 |
| Comp. Ex. 1 | SN100C | absent | 7.4×10$^3$ | 219 | 41.4×10$^{-6}$ | 67.1 | 1.00 | |
| Comp. Ex. 2A | SAC305 | present | 7.7×10$^3$ | 251 | 94.4×10$^{-6}$ | 182 | 2.82 | 96.5 |
| Comp. Ex. 2B | SAC305 | absent | 7.4×10$^3$ | 219 | 39.8×10$^{-6}$ | 64.5 | 1.00 | |
| Comp. Ex. 3A | Sn-5Sb | present | 7.6×10$^3$ | 267 | 73.9×10$^{-6}$ | 150 | 2.62 | 89.7 |
| Comp. Ex. 3B | Sn-5Sb | absent | 7.3×10$^3$ | 239 | 32.8×10$^{-6}$ | 57 | 1.00 | |

According to the results indicated in Table 1, the solder-metal mesh composite material obtained in example 1 contained the metal mesh therein, and thus its thermal conductivity was significantly increased to about three times the thermal conductivity of the sample 1 of comparative example 1.

(Test example 3)

A sample 2A was produced in the same manner as in example 1 except that SAC305 (composition: Sn-3Ag-0.5Cu) was used instead of SN100C, as the solder (comparative example 2A).

Similarly, a sample 3A was produced in the same manner as in example 1 except that Sn-5Sb was used instead of SN100C, as the solder (comparative example 3A).

A sample 2B and a sample 3B were produced in the same manners as in comparative example 2A and comparative example 3A, respectively, except that no metal mesh was used (comparative example 2B and comparative example 3B).

Subsequently, thermal conductivity of each of samples (n = 4) of comparative examples 2A, 2B, 3A, 3B was measured in the same manner as in test example 2.

The results are indicated in Table 1.

A proportion of the thermal conductivity of the sample having the metal mesh to the thermal conductivity of the sample having no metal mesh was calculated under the condition where the same solder alloy was used. Table 1 indicates the results of the calculation.

According to the results indicated in Table 1, the thermal conductivity of the solder-metal mesh composite material obtained in example 1 was highest in comparison with comparative examples 2A, 3A.

The thermal conductivity in a case where the mesh was present tended to be increased as compared with the thermal conductivity in the case of the mesh being absent. Particularly, when a proportion of the thermal conductivity of the solder-metal mesh composite material obtained in example 1 was 100, the thermal conductivity was higher than those of SAC305 (96.5) having been frequently used as a typical composition of lead-free solder and Sn-5Sb (89.7) having a high melting temperature.

For comparative example 2A, similarly to test example 1, a void occupancy in the cross-section in the thickness direction was measured using an X-ray fluoroscope for observing a radiographic image from the vertically upper side or the vertically lower side of the solder-metal mesh composite material 1 in accordance with IEC61191-6:2010.

Subsequently, an image was obtained by observing the cross-section in the thickness direction using a digital microscope, and FIG. 4 illustrates the image.

When measured through binarization based on the image illustrated in FIG. 4 in accordance with IEC61191-6:2010 (FIG. 5), the void occupancy in the cross-section in the thickness direction of the solder-metal mesh composite material 1 was 15.1%. A solder joint body of comparative example 2A was found to have significantly large voids.

The voids left as in a state of comparative example 2A cause reduction of thermal conductivity in the solder joint body and cause a power device to be inhibited from sufficiently exhibiting its performance. In addition, such voids may be a factor for reducing joint reliability required for electronic components.

The solder-metal mesh composite material formed with Sn-Cu-Ni-based lead-free solder containing 0.1 to 2% by weight of Cu, 0.002 to 1% by weight of Ni, 0.001 to 1% by weight of Ge, and Sn as a remainder is, for example, a joint member that has higher heat resistance, and has such high joint reliability as to exhibit more excellent thermal conductivity even in a case where a component generates heat in a high-voltage applied environment. Accordingly, the solder-metal mesh composite material is found to be preferably used as a joint member of a heat dissipating material such as a heatsink member and a joint member of an electronic component in a semiconductor device (power device) used in a power converter such as an inverter and a converter for an electric vehicle, a hybrid vehicle, an air conditioner, various types of general-purpose motors, and the like.

Furthermore, a solder-metal mesh composite material, in which lead-free solder containing 0.1 to 2% by weight of Cu, 0.002 to 1% by weight of Ni, and Sn as a remainder was used as Sn-Cu-Ni-based lead-free solder, was produced. Each measurement was performed on the produced material in the same manner as in test examples 1 and 2. As a result, according to each of the measurements, the number of the voids was significantly small and thermal conductivity was high, similarly to the solder-metal mesh composite material obtained in example 1.

Therefore, the solder-metal mesh composite material of the present invention in which the solder alloy is lead-free solder containing 0.1 to 2% by weight of Cu, 0.002 to 1% by weight of Ni, and Sn as a remainder is, for example, also a joint member that has higher heat resistance, and has such high joint reliability as to exhibit more excellent thermal conductivity even in a case where a component generates heat in a high-voltage applied environment. Accordingly, the solder-metal mesh composite material is found to be preferably used as a joint member of a heat dissipating material such as a heatsink member and a joint member of an electronic component in a semiconductor device (power device) used in a power converter such as an inverter and a converter for an electric vehicle, a hybrid vehicle, an air conditioner, various types of general-purpose motors, and the like.

DESCRIPTION OF THE REFERENCE CHARACTERS

1     solder-metal mesh composite material
2     composite layer formed of Sn-Cu-Ni-based lead-free solder
3     metal mesh having high thermal conductivity
4     Sn-Cu-Ni-based lead-free solder
5     solder-coated metal mesh
6     Sn-Cu-Ni-based lead-free solder sheet
7     heat resistant plate A
8     heat resistant plate B
9     heating device
10    spacer
11    void

**Claims**

1. A solder-metal mesh composite material, wherein

   a lead-free solder layer formed of Sn-Cu-Ni-based lead-free solder contains metal mesh having high thermal conductivity,
   a void occupancy in a cross-section in a thickness direction is 15% or less, and
   the Sn-Cu-Ni-based lead-free solder contains 0.1 to 2% by weight of Cu, 0.002 to 1% by weight of Ni, and Sn as a remainder or contains 0.1 to 2% by weight of Cu, 0.002 to 1% by weight of Ni, 0.001 to 1% by weight of Ge, and Sn as a remainder.

2. The solder-metal mesh composite material according to claim 1, wherein the metal mesh is copper mesh.

3. A solder joint body formed by using the solder-metal mesh composite material according to claim 1 or 2.

4. A method for producing a solder-metal mesh composite material, the method comprising:

   coating a surface of metal mesh having high thermal conductivity with Sn-Cu-Ni-based lead-free solder to obtain solder-coated metal mesh;
   disposing the solder-coated metal mesh between sheets of Sn-Cu-Ni-based lead-free solder and subsequently performing heating to a melting point of the Sn-Cu-Ni-based lead-free solder or a higher temperature while applying pressure, to melt the sheets of the lead-free solder; and
   cooling the melted solder until the melted solder is solidified, and collecting a solder-metal mesh composite material, wherein
   the Sn-Cu-Ni-based lead-free solder contains 0.1 to 2% by weight of Cu, 0.002 to 1% by weight of Ni, and Sn as a remainder or contains 0.1 to 2% by weight of Cu, 0.002 to 1% by weight of Ni, 0.001 to 1% by weight of Ge, and Sn as a remainder.

5. The method according to claim 4, wherein the metal mesh is copper mesh.

6. The production method according to claim 4 or 5, comprising disposing the sheet of the Sn-Cu-Ni-based lead-free solder, the solder-coated metal mesh, and the sheet of the Sn-Cu-Ni-based lead-free solder in order, between a heat resistant plate A and a heat resistant plate B, and subsequently performing heating from an outside of the heat resistant plate B while pressure is applied from an outside of the heat resistant plate A.

FIG. 1

# FIG. 2A

# FIG. 2B

## FIG. 3

## FIG. 4

FIG. 5

## INTERNATIONAL SEARCH REPORT

| International application No. |
| --- |
| PCT/JP2020/030074 |

A. CLASSIFICATION OF SUBJECT MATTER
B23K  1/00(2006.01)i;  C22C  13/00(2006.01)i;  B23K  35/14(2006.01)i;  B23K
35/26(2006.01)i; B23K 35/40(2006.01)i
FI:     B23K35/14 D;  B23K35/26 310A;  C22C13/00;  B23K1/00 8;  B23K1/00
        330E; B23K35/40 340H

According to International Patent Classification (IPC) or to both national classification and IPC

B. FIELDS SEARCHED

Minimum documentation searched (classification system followed by classification symbols)
B23K1/00; C22C13/00; B23K35/14; B23K35/26; B23K35/40

Documentation searched other than minimum documentation to the extent that such documents are included in the fields searched
| | |
| --- | --- |
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y<br>A | JP 2004-174522 A (HITACHI, LTD.) 24 June 2004 (2004-06-24) paragraphs [0024]-[0031], [0052]-[0063], [0113]-[0125], [0184], fig. 2 | 1–3<br>4–6 |
| Y<br>A | JP 3152945 B2 (NIHON SUPERIOR CO., LTD.) 03 April 2001 (2001-04-03) column 3, line 35 to column 5, line 6, fig. 1 | 1–3<br>4–6 |
| A | JP 2011-192695 A (MITSUBISHI ELECTRIC CORP.) 29 September 2011 (2011-09-29) | 1–6 |
| A | JP 52-39555 A (HITACHI, LTD.) 26 March 1977 (1977-03-26) | 1–6 |

☐ Further documents are listed in the continuation of Box C.      ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 16 October 2020 (16.10.2020) | 27 October 2020 (27.10.2020) |

| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |
| --- | --- |

Form PCT/ISA/210 (second sheet) (January 2015)

**INTERNATIONAL SEARCH REPORT**
Information on patent family members

International application No.

PCT/JP2020/030074

| Patent Documents referred in the Report | Publication Date | Patent Family | Publication Date |
|---|---|---|---|
| JP 2004-174522 A | 24 Jun. 2004 | (Family: none) | |
| JP 3152945 B2 | 03 Apr. 2001 | US 6180055 B1 column 1, line 41 to column 3, line 10, tables US 6296722 B1 WO 1999/048639 A1 WO 2000/024544 A1 EP 985486 A1 EP 1043112 A1 DE 69918758 T2 DE 69918261 T2 AU 4119799 A CA 2288817 A1 HK 1026390 A1 TW 411731 B AU 757312 B ID 22854 A ES 2224609 T3 CN 1262638 A MY 114845 A KR 10-2001-0012869 A AT 269776 T HK 1031844 A1 JP 2000-197988 A JP 2007-203373 A | |
| JP 2011-192695 A | 29 Sep. 2011 | US 2011/0221076 A1 DE 102011002535 A1 CN 102194784 A | |
| JP 52-39555 A | 26 Mar. 1977 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ADRIAN LIS et al.** *Materials and Design,* 2018, vol. 160, 475-485